# EUROPEAN PATENT SPECIFICATION

(11) **EP 3 604 445 B1**
(45) Date of publication and mention of the grant of the patent: **12.04.2023**
(21) Application number: 18777260.3
(22) Date of filing: 05.02.2018
(51) Int. Cl.: C08L 75/04, C08K 3/00, C08K 5/375, C09K 3/10, C09K 15/14, C08G 18/36, C08G 18/76, C08G 18/79, C08K 3/22, C08K 5/00, C08K 5/372, H01L 23/29

(54) **POLYURETHANE RESIN COMPOSITION AND SEALED OBJECT**
POLYURETHANHARZZUSAMMENSETZUNG UND VERSIEGELTER GEGENSTAND
COMPOSITION DE RÉSINE DE POLYURÉTHANE ET OBJET SCELLÉ

(30) Priority: 30.03.2017 JP 2017067361
(43) Date of publication of application: 05.02.2020
(73) Proprietor: Dai-Ichi Kogyo Seiyaku Co., Ltd., Kyoto-shi, Kyoto 600-8873 (JP)
(72) Inventor: KANAI, Azusa, kyoto-shi Kyoto 600-8873 (JP); ISHINO, Mana, kyoto-shi Kyoto 600-8873 (JP)
(74) Representative: TBK
(86) International application number: PCT/JP2018/003865
(87) International publication number: WO 2018/179845

(56) References cited:
- WO-A1-2011/062187
- JP-A- H0 249 059
- JP-A- S59 115 354
- JP-A- 2001 316 434
- JP-A- 2016 169 316
- JP-A- 2016 169 316
- PL-B1- 206 101
- US-A- 5 554 712
- US-A- 5 698 371
- US-A1- 2012 231 269
- US-A1- 2014 127 504

## Description

### Technical Field

The present invention relates to a polyurethane resin composition and a sealed article.

### Background Art

Polyurethane resin compositions are used to seal objects such as electrical and electronic components in order to provide protection from condensation and contamination (PTL 1). Such polyurethane resin compositions are often used in high-temperature environments.

US 2012/231269 A1 relates to a composite film that includes at least a urethane polymer.

PL 206101 B1 relates to two-component polyurethane gluing-sealing compound.

US 5554712 A relates to a photopolymer prepared by preparing a urethane prepolymer by reacting polyoxyalkylene diols or polyester diols, or a mixture thereof, with an excess of diisocyanate, followed by chain extending the resulting prepolymer mixture with an alkyldialkanolamine, then reacting the chain-extended product with a hydroxyalkyl(meth)acrylate.

US 2014/127504 A1 relates to a urethane-based pressuresensitive adhesive including a polyurethane-based resin, in which: the polyurethane-based resin includes a polyurethane-based resin obtained by curing a composition containing a polyol and a polyfunctional isocyanate compound; and the polyurethane-based resin contains a deterioration-preventing agent.

JP 2016-169316 A relates to a polyurethane resin composition that contains polyol, polyisocyanate, a plasticizer, an inorganic filler, and a phenolic antioxidant containing no sulfur atom in a molecule.

US 5698371 A relates to a photocurable composition prepared by blending a urethane (meth)acrylate prepolymer with a complexing polymer based on poly(vinyl pyrrolidone) composition.

### Citation List

### Patent Literature

PTL 1: Japanese Unexamined Patent Application Publication No. 2008-231348
PTL 2: Japanese Unexamined Patent Application Publication No. 2001-352156

### Summary of Invention

### Technical Problem

However, if a polyurethane resin composition is softened or melted when exposed to a high-temperature environment, the polyurethane resin composition may fail to properly protect an object to be sealed.

This invention has been made to solve the above problem, and an object thereof is to provide a polyurethane resin composition having high heat resistance.

### Solution to Problem

To solve the above problem, the present inventors have intensively studied and found that the above problem can be solved by using a raw material having a specific structure, thereby completing the present invention.

Specifically, a polyurethane resin composition of the present invention is obtained by reacting a hydroxyl-group-containing compound (A) with an isocyanate-group-containing compound (B) and contains an antioxidant (C) having an alkylthio group, wherein the polyurethane resin composition further comprises an inorganic filler (D), and a sodium content of the inorganic filler (D) is 0.15 mass% or less of the inorganic filler (D) on a Na₂O basis..

In the present invention, the polyurethane resin composition is meant to include those during and after being cured by the reaction between the hydroxyl-group-containing compound (A) and the isocyanate-group-containing compound (B) .

### Advantageous Effects of Invention

The present invention can provide a polyurethane resin composition having high heat resistance.

### Description of Embodiments

First, embodiments of the present invention will be enumerated.
(1) A polyurethane resin composition according to an embodiment of the present invention is obtained by reacting a hydroxyl-group-containing compound (A) with an isocyanate-group-containing compound (B) and contains an antioxidant (C) having an alkylthio group. Due to this configuration, the heat resistance of the polyurethane resin composition can be improved. The polyurethane resin composition further contains an inorganic filler (D), and the sodium content of the inorganic filler (D) is 0.15 mass% or less of the inorganic filler (D) on a Na₂O basis. Due to this configuration, the heat resistance of the polyurethane resin composition can be further improved.
(2) Preferably, the antioxidant (C) is a phenol compound having the alkylthio group. Due to this configuration, the heat resistance of the polyurethane resin composition can be more effectively improved.
(3) Preferably, the polyurethane resin composition further contains an inorganic filler (D), and the polyurethane resin composition contains the inorganic filler (D) in an amount of 20 parts by mass to 80 parts by mass based on 100 parts by mass of the polyurethane resin composition. Due to this configuration, for example, the polyurethane resin composition can be provided with high thermal conductivity, and mixing viscosity during the preparation of the polyurethane resin composition can be controlled to be in a range suitable for use.
(4) Preferably, the polyurethane resin composition contains the antioxidant (C) in an amount of 0.05 parts by mass to 2.0 parts by mass based on 100 parts by mass of the polyurethane resin composition. Due to this configuration, precipitation of the antioxidant on a surface of the polyurethane resin composition can be prevented while reducing deterioration of the polyurethane resin composition.
(5) A sealed article according to an embodiment of the present invention is sealed by the polyurethane resin composition according to any one of (1) to (4) above. Due to this configuration, an object to be sealed by the polyurethane resin composition having high heat resistance can properly be protected.

The embodiments of the present invention will now be described in detail.

The hydroxyl-group-containing compound (A) in the embodiments may be, for example, but is not limited to, a castor oil-based polyol, a polyether polyol, a polymer polyol, a low-molecular-weight glycol, a polyester polyol, a polybutadiene polyol, a polyisoprene polyol, a dimer acid polyol, a hydrogenated polybutadiene polyol, or a hydrogenated polyisoprene polyol. Two or more of them may be used in combination.

For improved heat resistance, a castor oil-based polyol is preferably contained as the hydroxyl-group-containing compound (A). When a castor oil-based polyol and other polyols are used in combination, the amount of castor oil-based polyol is preferably 60 mass% or more, more preferably 70 mass% or more, still more preferably 80 mass% or more, based on the total amount of the polyols used.

Examples of usable castor oil-based polyols include, but are not limited to, castor oil, hydrogenated castor oil, transesterification products of castor oil and other fatty oils, reaction products of castor oil and polyhydric alcohols, esterification reaction products of castor oil fatty acids and polyhydric alcohols, and addition polymerization products thereof with alkylene oxides. Two or more of them may be used in combination.

Examples of usable polyether polyols include, but are not limited to, ring-opening polymerization products obtained from alkylene oxides (hereinafter also referred to as "AOs") and initiators such as water, propylene glycol, ethylene glycol, glycerol, trimethylolpropane, hexanetriol, triethanolamine, diglycerol, pentaerythritol, ethylenediamine, methyl glucoside, aromatic diamines, sorbitol, sucrose, and phosphoric acid. Two or more of them may be used in combination. Preferred initiators are those obtained by using water, propylene glycol, ethylene glycol, glycerol, trimethylolpropane, or hexanetriol as a starting material, and preferred AOs are ethylene oxide, propylene oxide, and butylene oxide.

Examples of usable polymer polyols include, but are not limited to, polymer polyols obtained by reacting the above polyether polyols with ethylenically unsaturated monomers (e.g., butadiene, acrylonitrile, and styrene) in the presence of radical polymerization catalysts. Two or more of them may be used in combination.

Examples of usable low-molecular-weight glycols include, but are not limited to, aliphatic diols such as ethylene glycol, 1,2-propanediol, 1,3-propanediol, 1,3-butanediol, 1,4-butanediol, 1,5-pentanediol, 1,6-hexanediol, neopentyl glycol, diethylene glycol, triethylene glycol, tetraethylene glycol, dipropylene glycol, tripropylene glycol, 3-methyl-1,5-pentanediol, 2-butyl-2-ethyl-1,3-propanediol, and 2-methyl-1,3-propanediol; alicyclic diols such as 1,4-cyclohexanediol, 1,4-cyclohexanedimethanol, and hydrogenated bisphenol A; and tri- or higher functional hydroxyl-group-containing compounds such as glycerol, trimethylolpropane, and pentaerythritol. Two or more of them may be used in combination.

Examples of usable polyester polyols include, but are not limited to, condensation reaction products of polyhydroxyl-group-containing compounds and polycarboxylic acids (aromatic polycarboxylic acids and aliphatic polycarboxylic acids) or ester-forming derivatives (e.g., phthalic anhydride and dimethyl terephthalate) such as anhydrides and lower alkyl (C1 to C4 alkyl) esters thereof; polylactone polyols; polycarbonate polyols; and castor oil derivatives [e.g., polyester polyols formed from castor oil fatty acids and polyhydric alcohols or polyoxyalkylene polyols (e.g., mono- or diglycerides formed from castor oil fatty acids, mono-, di-, or triesters formed from castor oil fatty acids and trimethylolpropane, and mono- or diesters formed from castor oil fatty acids and polyoxypropylene glycols); alkylene (C2 to C4) oxide adducts of castor oil; and hydroxyl-group-terminated prepolymers derived from castor oil and diphenylmethane diisocyanate]. Two or more of them may be used in combination.

Examples of usable dimer acid polyols include, but are not limited to, reaction products of dimer acids and diols, triols, polyalkylene glycols, or polyalkylene triols. Two or more of them may be used in combination. A dimer acid polyol having a weight-average molecular weight (Mw) of 300 to 50000 is preferred. The average number of functional groups per molecule of the dimer acid polyol is preferably 2 to 4. The hydroxyl value of the dimer acid polyol is preferably 2 mgKOH/g or more, more preferably 30 mgKOH/g or more. The hydroxyl value of the dimer acid polyol is preferably 800 mgKOH/g or less, more preferably 500 mgKOH/g or less, still more preferably 300 mgKOH/g or less.

Examples of usable polybutadiene polyols, polyisoprene polyols, hydrogenated polybutadiene polyols, and hydrogenated polyisoprene polyols include, but are not limited to, those which are commonly used for polyurethane resin compositions.

In the embodiments, the hydroxyl-group-containing compound (A) may be, for example, a hydroxyl-group-terminated urethane prepolymer obtained by reacting a hydroxyl-group-containing compound with an isocyanate-group-containing compound.

In view of moldability of molded products, the content of the hydroxyl-group-containing compound (A) is preferably 5 parts by mass or more, more preferably 10 parts by mass or more, still more preferably 20 parts by mass or more, based on 100 parts by mass of the polyurethane resin composition. In view of moldability of molded products, the content of the hydroxyl-group-containing compound (A) is preferably 80 parts by mass or less, more preferably 70 parts by mass or less, still more preferably 60 parts by mass or less, based on 100 parts by mass of the polyurethane resin composition.

The isocyanate-group-containing compound (B) in the embodiments may be, for example, but is not limited to, an aliphatic polyisocyanate compound, an alicyclic polyisocyanate compound, an aromatic polyisocyanate compound, an araliphatic polyisocyanate compound, or a modified product of any of these isocyanate compounds. Two or more of them may be used in combination. The isocyanate-group-containing compound (B) is preferably an aliphatic polyisocyanate compound, an aromatic polyisocyanate compound, or a modified product of any of these isocyanate compounds.

Examples of usable aliphatic polyisocyanate compounds include tetramethylene diisocyanate, dodecamethylene diisocyanate, hexamethylene diisocyanate (HDI), 2,2,4-trimethylhexamethylene diisocyanate, 2,4,4-trimethylhexamethylene diisocyanate, lysine diisocyanate, 2-methylpentane-1,5-diisocyanate, and 3-methylpentane-1,5-diisocyanate. Two or more of them may be used in combination.

Examples of usable alicyclic polyisocyanate compounds include isophorone diisocyanate, hydrogenated xylylene diisocyanate, 4,4'-dicyclohexylmethane diisocyanate, 1,4-cyclohexane diisocyanate, methylcyclohexylene diisocyanate, and 1,3-bis(isocyanatomethyl)cyclohexane. Two or more of them may be used in combination.

Examples of usable aromatic polyisocyanate compounds include dialkyl diphenylmethane diisocyanate, tolylene diisocyanate, 2,2'-diphenylmethane diisocyanate, 2,4'-diphenylmethane diisocyanate, 4,4'-diphenylmethane diisocyanate (monomeric MDI), polymethylene polyphenyl polyisocyanate (polymeric MDI), 4,4'-dibenzyl diisocyanate, 1,5-naphthylene diisocyanate, 1,3-phenylene diisocyanate, and 1,4-phenylene diisocyanate. Two or more of them may be used in combination.

Examples of usable araliphatic polyisocyanate compounds include xylylene diisocyanate, tetraalkyl diphenylmethane diisocyanate, and **α,α,α,α**-tetramethylxylylene diisocyanate. Two or more of them may be used in combination.

Examples of usable modified products of polyisocyanate compounds include isocyanurate-modified products, biuretmodified products, adduct-modified products, carbodiimide-modified products, and bifunctional-modified products. Two or more of them may be used in combination.

In the embodiments, the isocyanate-group-containing compound (B) may be, for example, an isocyanate-group-terminated urethane prepolymer obtained by reacting a hydroxyl-group-containing compound with an isocyanate-group-containing compound.

In view of moldability of molded products, the content of the isocyanate-group-containing compound (B) is preferably 0.5 parts by mass or more, more preferably 1 part by mass or more, still more preferably 1.5 parts by mass or more, based on 100 parts by mass of the polyurethane resin composition. In view of moldability of molded products, the content of the isocyanate-group-containing compound (B) is preferably 80 parts by mass or less, more preferably 70 parts by mass or less, still more preferably 60 parts by mass or less, further more preferably 50 parts by mass or less, based on 100 parts by mass of the polyurethane resin composition.

In the embodiments, the molar ratio (NCO/OH) of the isocyanate group in the isocyanate-group-containing compound (B) to the hydroxyl group in the hydroxyl-group-containing compound (A) is preferably 0.6 or more, more preferably 0.8 or more. If the molar ratio is below this range, insufficient curing may occur, and a resin having low heat resistance may be provided. The molar ratio is preferably 1.5 or less, more preferably 1.3 or less. If the molar ratio is above this range, insufficient curing may occur.

The antioxidant (C) in the embodiments has an alkylthio group. In view of the heat resistance of the polyurethane resin composition, the number of carbon atoms in the alkylthio group is preferably 6 or more, more preferably 7 or more, still more preferably 8 or more. The antioxidant (C) having an alkylthio group may be, for example, 2,2-bis[[3-(dodecylthio)-1-oxopropyloxy]methyl]-1,3-propanediyl bis[3-(dodecylthio)propionate] (SUMILIZER TP-D manufactured by Sumitomo Chemical Co., Ltd.), 2,4-bis(octylthiomethyl)-6-methylphenol (IRGANOX 1520L manufactured by BASF), or 4-[[4,6-bis(octylthio)-1,3,5-triazin-2-yl]amino]-2,6-di-tertbutylphenol (IRGANOX 565 manufactured by BASF). Two or more of them may be used in combination.

For improved heat resistance, the antioxidant (C) is preferably a phenol compound. Examples of the antioxidant (C) that has an alkylthio group and is also a phenol compound include IRGANOX 1520L and IRGANOX 565.

For improved heat resistance, the antioxidant (C) preferably has a triazine ring. Examples of the antioxidant (C) having an alkylthio group and a triazine ring include IRGANOX 565. For improved heat resistance, the antioxidant (C) is more preferably a phenol compound having an alkylthio group and a triazine ring. The antioxidant (C) may be used in combination with another antioxidant.

The amount of the antioxidant (C) is preferably 2.0 parts by mass or less, more preferably 1.5 parts by mass or less, based on 100 parts by mass of the polyurethane resin composition. The amount of the antioxidant (C) is preferably 0.05 parts by mass or more, more preferably 0.1 parts by mass or more, based on 100 parts by mass of the polyurethane resin composition.

An inorganic filler (D) is added to the polyurethane resin composition. The inorganic filler (D) is used in order, for example, to increase thermal conductivity and heat dissipation properties of the polyurethane resin composition. When the object to be sealed by the polyurethane resin composition is an exothermic body such as an electrical or electronic component, the polyurethane resin composition is required to have thermal conductivity and heat dissipation properties at or above certain levels. The inorganic filler (D) may be, for example, alumina, aluminum hydroxide, aluminum nitride, boron nitride, magnesium hydroxide, or magnesium oxide.

The sodium content of the inorganic filler (D) is 0.15 mass% or less, preferably 0.10 mass% or less, of the inorganic filler (D) on a Na₂O basis. When the sodium content of the inorganic filler (D) is not more than these values, the heat resistance can be more effectively increased.

To increase the thermal conductivity and heat dissipation properties of the polyurethane resin composition, the amount of the inorganic filler (D) is preferably 20 parts by mass or more, more preferably 30 parts by mass or more, based on 100 parts by mass of the polyurethane resin composition. To reduce the mixing viscosity during the production of the polyurethane resin composition, the amount of the inorganic filler (D) is preferably 90 parts by mass or less, more preferably 80 parts by mass or less, based on 100 parts by mass of the polyurethane resin composition. When the mixing viscosity during the production is high, the workability tends to be low.

A plasticizer (E) can be added to the polyurethane resin composition in the embodiments. The plasticizer (E) may be a known one used for polyurethane resins. For example, phthalates such as dioctyl phthalate, diisononyl phthalate, and diundecyl phthalate; non-phthalate compounds such as diisononyl 1,2-cyclohexanedicarboxylate; adipates such as dioctyl adipate and diisononyl adipate; castor oil-based esters such as methyl acetyl ricinoleate, butyl acetyl ricinoleate, acetylricinoleic triglyceride, and acetylpolyricinoleic triglyceride; trimellitates such as trioctyl trimellitate and triisononyl trimellitate; pyromellitates such as tetraoctyl pyromellitate and tetraisononyl pyromellitate; and phosphates such as tricresyl phosphate, trixylyl phosphate, cresyl diphenyl phosphate, xylenyl phosphate, and triphenyl phosphate can be used.

The amount of the plasticizer (E) is preferably 30 parts by mass or less, more preferably 25 parts by mass or less, still more preferably 20 parts by mass or less, based on 100 parts by mass of the polyurethane resin composition. A large amount of plasticizer may degrade physical properties, such as strength, of the polyurethane resin composition.

Optionally, various additives such as catalysts, antioxidants, moisture absorbents, antifungal agents, and silane coupling agents can be added to the polyurethane resin composition in the embodiments. Examples of silane coupling agents include alkoxysilanes, vinyl-group-containing silane coupling agents, epoxy-group-containing silane coupling agents, methacrylic-group-containing silane coupling agents, and acrylic-group-containing silane coupling agents.

In the case of, for example, raw materials at 25°C are mixed together, the mixing viscosity during the production of the polyurethane resin composition in the embodiments is preferably 5 Pa·s or less, more preferably 4 Pa·s or less. A mixing viscosity of not more than these values provides good workability. The mixing viscosity is measured by a method described in EXAMPLES.

When the object to be sealed is an exothermic body such as an electrical or electronic component, the thermal conductivity of the polyurethane resin composition in the embodiments is preferably 0.3 W/m·K or more, more preferably 0.4 W/m·K or more. The thermal conductivity is measured by a method described in EXAMPLES.

The polyurethane resin composition in the embodiments can seal articles such as electrical and electronic components, medical supplies, toys, and housewares. Articles in the state of being sealed by the polyurethane resin composition are also referred to as sealed articles.

### EXAMPLES

The polyurethane resin composition in the embodiments will now be described in more detail with reference to Examples, Reference Examples and Comparative Examples. It should be understood that the present invention is not limited to the examples. "Parts" and "%" in this DESCRIPTION indicate "parts by mass" and "mass%", respectively, unless otherwise specified.

Raw materials used in Examples and Comparative Examples will be described.

### [Hydroxyl-group-containing compound]

· Hydroxyl-group-containing compound (A1): vegetable oil fatty acid-polyhydric alcohol ester
   (Trade name: HS2T-166H, manufactured by HOKOKU Co., Ltd.)
· Hydroxyl-group-containing compound (A2): castor oil-based polyol
   (Trade name: URIC H-57, manufactured by Itoh Oil Chemicals Co., Ltd.)
· Hydroxyl-group-containing compound (A3): castor oil
   (Trade name: CASTOR OIL D, manufactured by Itoh Oil Chemicals Co., Ltd.)

### [Isocyanate-group-containing compound]

· Isocyanate-group-containing compound (B1): polymeric MDI
   (Trade name: MILLIONATE MR-200, manufactured by Tosoh Corporation)
· Isocyanate-group-containing compound (B2): carbodiimide-modified product of MDI
   (Trade name: LUPRANATE MM103, manufactured by BASF INOAC Polyurethanes Ltd.)
· Isocyanate-group-containing compound (B3): nuratemodified product of HDI
   (Trade name: DURANATE TLA-100, manufactured by Asahi Kasei Chemicals Corporation)

### [Antioxidant]

· Antioxidant (C1): alkylthio-group-containing antioxidant (4-[[4,6-bis(octylthio)-1,3,5-triazin-2-yl]amino]-2,6-di-tert-butylphenol)
   (Trade name: IRGANOX 565, manufactured by BASF)
· Antioxidant (C2): alkylthio-group-containing antioxidant (2,4-bis(octylthiomethyl)-6-methylphenol)
   (Trade name: IRGANOX 1520L, manufactured by BASF)
· Antioxidant (Cc): alkylthio-group-non-containing antioxidant (pentaerythritol tetrakis[3-(3,5-di-tert-butyl-4-hydroxyphenyl)propionate])
   (Trade name: ADK STAB AO-60, manufactured by ADEKA Corporation)

### [Inorganic filler]

· Inorganic filler (D1): aluminum hydroxide (sodium content (on a Na₂O basis): 0.02 mass%)
   (Trade name: BE-043, manufactured by Nippon Light Metal Company, Ltd.)
· Inorganic filler (D2): aluminum hydroxide (sodium content (on a Na₂O basis): 0.07 mass%)
   (Trade name: CL-310, manufactured by Sumitomo Chemical Co., Ltd.)
· Inorganic filler (D3): alumina (sodium content (on a Na₂O basis): 0.07 mass%)
   (Trade name: LS-220, manufactured by Nippon Light Metal Company, Ltd.)
· Inorganic filler (D4): aluminum hydroxide (sodium content (on a Na₂O basis): 0.17%)
   (Trade name: C-305, manufactured by Sumitomo Chemical Co., Ltd.)

### [Plasticizer]

### • Plasticizer (E1): diundecyl phthalate

(Trade name: SANSO CIZER DUP, manufactured by New Japan Chemical Co., Ltd.)

Table 1 shows raw materials used to form polyurethane resin compositions of Examples 1 to 13, Reference Examples 14 and 15, and Comparative Examples 1 to 3, the amount thereof (parts by mass), and results of evaluations described below.

### <Preparation of polyurethane resin composition>

A mixture of raw materials excluding the isocyanate-group-containing compound (B) was mixed using a disperser (manufactured by PRIMIX Corporation, model name: TK HOMOGENIZING DISPER Model 2.5) for 30 minutes. Thereafter, the isocyanate-group-containing compound (B) was added so as to achieve NCO/OH = 1 to 1.1, and mixing and defoaming were performed. Using the polyurethane resin composition thus prepared, heat resistance, thermal conductivity, and mixing viscosity were evaluated as described below.

### <Regarding heat resistance>

### 1. Production of test piece for heat resistance evaluation

The uncured polyurethane resin composition prepared was poured into a cylindrical mold with a diameter of 5 cm to a level of 3 cm and allowed to stand in an environment at 80°C for 16 hours, thereby curing the polyurethane resin composition. Thereafter, the cured polyurethane resin composition was demolded to obtain a test piece for heat resistance evaluation.

### 2. Evaluation of heat resistance

A test piece (hereinafter also referred to as an unheated test piece) allowed to stand in a room-temperature environment for 24 hours and a test piece (hereinafter also referred to as a heated test piece) allowed to stand in a high-temperature environments at 150°C for 24 hours were prepared. The unheated test piece and the heated test piece were then measured for their surface hardness (type A) in accordance with JIS K6253. Hardness retention (%), as defined as the percentage of the hardness of the heated test piece relative to the hardness of the unheated test piece, was evaluated according to the following evaluation criteria.
**⊙:** Hardness retention is 70% or more, and neither melting nor appearance change is observed in heated test piece.
○: Hardness retention is less than 70%, and neither melting nor appearance change is observed in heated test piece.
×: Melting or appearance change is observed in heated test piece (hardness is not measured).

### <Regarding thermal conductivity>

### 1. Production of test piece for thermal conductivity evaluation

The uncured polyurethane resin composition prepared was poured into a box-shaped mold with a bottom of 6 cm × 12 cm to a level of 1 cm and allowed to stand in an environment at 80°C for 16 hours, thereby curing the polyurethane resin composition. Thereafter, the cured polyurethane resin composition was demolded to obtain a test piece for thermal conductivity evaluation.

### 2. Evaluation of thermal conductivity

The thermal conductivity of the test piece was measured by a probe method using a thermal conductivity meter (QTM-D3 manufactured by Kyoto Electronics Manufacturing Co., Ltd.).

### <Regarding mixing viscosity>

The mixing viscosity in preparing the polyurethane resin composition was measured. Specifically, the isocyanate-group-containing compound (B) was added to the mixture of raw materials excluding the isocyanate-group-containing compound (B), and mixing was started. The mixing viscosity after five minutes was measured using a BH type viscometer. The temperature of the raw materials and the ambient temperature during the mixing are 25°C.

### <Evaluation results>

Referring to the evaluation results in Table 1, the polyurethane resin compositions of Examples 1 to 13, Reference Examples 14 and 15 each have high heat resistance, a good thermal conductivity, and, in addition, a mixing viscosity in a range suitable for use. Comparison of Examples 1 to 13 and Reference Examples 14 and 15 shows that combined use of an antioxidant containing an alkylthio group and an inorganic filler with a sodium content (on a Na₂O basis) of 0.10 mass% or less can more effectively increase the heat resistance of the polyurethane resin composition. It can also be seen that the heat resistance is significantly worse when an antioxidant not containing an alkylthio group is used as in Comparative Examples 1 to 3 than when an antioxidant containing an alkylthio group is used.

**[Table 1]**

| | | Example | | | | | | | | | | | | | Reference Example | | Comparative Example | | |
|---|---|---|---|---|---|---|---|---|---|---|---|---|---|---|---|---|---|---|---|
| | | 1 | 2 | 3 | 4 | 5 | 6 | 7 | 8 | 9 | 10 | 11 | 12 | 13 | 14 | 15 | 1 | 2 | 3 |
| | Hydroxyl-group-containing compound (A1) | 47.5 | | | 47.5 | 46 | 47.5 | 47.5 | 61 | 12.7 | 47.5 | 47.5 | 47 | 48 | 47.5 | 47.5 | 47.5 | 47.5 | 47.5 |
| | Hydroxyl-group-containing compound (A2) | | 43.5 | | | | | | | | | | | | | | | | |
| | Hydroxyl-group-containing compound (A3) | | | 38.5 | | | | | | | | | | | | | | | |
| | Isocyanate-group-containing compound (B1) | 7 | 11 | 16 | | | 7 | 7 | 8.5 | 1.8 | 7 | 7 | 7 | 6.9 | 7 | 7 | 7 | 7 | 7 |
| | Isocyanate-group-containing compound (B2) | | | | 7 | | | | | | | | | | | | | | |
| | Isocyanate-group-containing compound (B3) | | | | | 8.5 | | | | | | | | | | | | | |
| | Antioxidant (C1) (containing alkylthio group) | 0.5 | 0.5 | 0.5 | 0.5 | 0.5 | 0.5 | 0.5 | 0.5 | 0.5 | | | 1.0 | 0.1 | 0.5 | | | | |
| Raw materials | Antioxidant (C2) (containing alkylthio group) | | | | | | | | | | 0.5 | 0.5 | | | | 0.5 | | | |
| | Antioxidant (Cc) (not containing alkylthio group) | | | | | | | | | | | | | | | | 0.5 | 0.5 | 0.5 |
| | Inorganic filler (D1) (sodium:0.02 mass%) | 45 | 45 | 45 | 45 | 45 | | | 30 | 70 | 45 | | 45 | 45 | | | 45 | | |
| | Inorganic filler (D2) (sodium:0.07 mass%) | | | | | | 45 | | | | | | | | | | | | |
| | Inorganic filler (D3) (sodium:0.07 mass%) | | | | | | | 45 | | | | 45 | | | | | | 45 | |
| | Inorganic filler (D4) (sodium:0.17 mass%) | | | | | | | | | | | | | | 45 | 45 | | | 45 |
| | Plasticizer (E1) | | | | | | | | | 15 | | | | | | | | | |
| | (Total) | 100 | 100 | 100 | 100 | 100 | 100 | 100 | 100 | 100 | 100 | 100 | 100 | 100 | 100 | 100 | 100 | 100 | 100 |
| Evaluation results | Heat resistance | ⊙ | ⊙ | ⊙ | ⊙ | ⊙ | ⊙ | ⊙ | ⊙ | ⊙ | ⊙ | ⊙ | ⊙ | ⊙ | ○ | ○ | × | × | × |
| | Thermal conductivity (W/(m·k)) | 0.6 | 0.6 | 0.6 | 0.6 | 0.6 | 0.6 | 0.6 | 0.4 | 0.8 | 0.6 | 0.6 | 0.6 | 0.6 | 0.6 | 0.6 | 0.6 | 0.6 | 0.6 |
| | Mixing viscosity (Pa·s) | 3 | 2 | 2 | 3 | 4 | 3 | 2 | 2 | 3 | 3 | 2 | 3 | 3 | 3 | 3 | 3 | 3 | 2 |

## Claims

1. A polyurethane resin composition obtained by reacting a hydroxyl-group-containing compound (A) with an isocyanate-group-containing compound (B), the polyurethane resin composition comprising an antioxidant (C) having an alkylthio group, wherein the polyurethane resin composition further comprises an inorganic filler (D), and a sodium content of the inorganic filler (D) is 0.15 mass% or less of the inorganic filler (D) on a NazO basis.

2. The polyurethane resin composition according to Claim 1, wherein the antioxidant (C) is a phenol compound having the alkylthio group.

3. The polyurethane resin composition according to Claim 1 or 2, wherein the polyurethane resin composition further comprises an inorganic filler (D), and the polyurethane resin composition comprises the inorganic filler (D) in an amount of 20 parts by mass to 80 parts by mass based on 100 parts by mass of the polyurethane resin composition.

4. The polyurethane resin composition according to any one of Claims 1 to 3, wherein the polyurethane resin composition comprises the antioxidant (C) in an amount of 0.05 parts by mass to 2.0 parts by mass based on 100 parts by mass of the polyurethane resin composition.

5. A sealed article sealed by the polyurethane resin composition according to any one of Claims 1 to 4.

## Patentansprüche

1. Polyurethanharzzusammensetzung, erhalten durch Reagieren einer Hydroxylgruppe-enthaltenden Verbindung (A) mit einer Isocyanatgruppeenthaltenden Verbindung (B), wobei die Polyurethanharzzusammensetzung ein Antioxidationsmittel (C) mit einer Alkylthiogruppe umfasst, wobei die Polyurethanharzzusammensetzung ferner einen anorganischen Füllstoff (D) umfasst und ein Natriumgehalt des anorganischen Füllstoffs (D) 0,15 Massen-% oder weniger des anorganischen Füllstoffs (D) auf NazO-Basis beträgt.

2. Polyurethanharzzusammensetzung nach Anspruch 1, wobei das Antioxidationsmittel (C) eine Phenolverbindung mit der Alkylthiogruppe ist.

3. Polyurethanharzzusammensetzung nach Anspruch 1 oder 2, wobei die Polyurethanharzzusammensetzung ferner einen anorganischen Füllstoff (D) umfasst und die Polyurethanharzzusammensetzung den anorganischen Füllstoff (D) in einer Menge von 20 Massenteilen bis 80 Massenteilen, bezogen auf 100 Massenteile der Polyurethanharzzusammensetzung, umfasst.

4. Polyurethanharzzusammensetzung nach einem der Ansprüche 1 bis 3, wobei die Polyurethanharzzusammensetzung das Antioxidationsmittel (C) in einer Menge von 0,05 Massenteilen bis 2,0 Massenteilen, bezogen auf 100 Massenteile der Polyurethanharzzusammensetzung, umfasst.

5. Versiegelter Gegenstand, der durch der Polyurethanharzzusammensetzung nach einem der Ansprüche 1 bis 4 versiegelt ist.

## Revendications

1. Composition de résine de polyuréthane obtenue par mise en réaction d'un composé contenant un groupe hydroxyle (A) avec un composé contenant un groupe isocyanate (B), la composition de résine de polyuréthane comprenant un antioxydant (C) possédant un groupe alkylthio, la composition de résine de polyuréthane comprenant en outre une charge inorganique (D), et une teneur en sodium de la charge inorganique (D) étant de 0,15 % en masse ou moins de la charge inorganique pour (D) sur une base de NazO.

2. Composition de résine de polyuréthane selon la revendication 1, l'antioxydant (C) étant un composé de type phénol possédant le groupe alkylthio.

3. Composition de résine de polyuréthane selon la revendication 1 ou 2, la composition de résine de polyuréthane comprenant en outre une charge inorganique (D), et la composition de résine de polyuréthane comprenant la charge inorganique (D) en une quantité de 20 parties en masse à 80 parties en masse sur la base de 100 parties en masse de la composition de résine de polyuréthane.

4. Composition de résine de polyuréthane selon l'une quelconque des revendications 1 à 3, la composition de résine de polyuréthane comprenant l'antioxydant (C) en une quantité de 0,05 partie en masse à 2,0 parties en masse sur la base de 100 parties en masse de la composition de résine de polyuréthane.

5. Article scellé scellé par la composition de résine de polyuréthane selon l'une quelconque des revendications 1 à 4.
